# EUROPEAN PATENT APPLICATION

(11) **EP 0 952 664 A1**
(43) Date of publication of application: **27.10.1999**
(21) Application number: 99107622.5
(22) Date of filing: 16.04.1999
(51) Int. Cl.: H03C 1/54, H03C 1/58

(54) **Sub-harmonic modulator**

(30) Priority: 20.04.1998 EP 98107148
(71) Applicant: THE WHITAKER CORPORATION, Wilmington, Delaware 19808 (US)
(72) Inventor: Doyle, Ian Stephen, Bandon, Co. Cork (IE); Norton, David Elliot, Framingham, MA 01702 (US)
(74) Representative: Heinz-Schäfer, Marion

(57) **Abstract**

A sub-harmonic I-Q modulator (2) comprises a pair of harmonic mixers (4, 5) that produce an operating output signal of double the LO frequency. A 45° phase shifter is positioned between the LO input and mixers, such that the operating frequency (2LO) has a phase shift of 90°. This provides a simpler and more economical phase shifter whilst maintaining the advantages of conventional harmonic modulators, such as lower LO frequency.

## Description

This invention relates to a signal modulator, particularly for operation in the range of microwave frequencies.

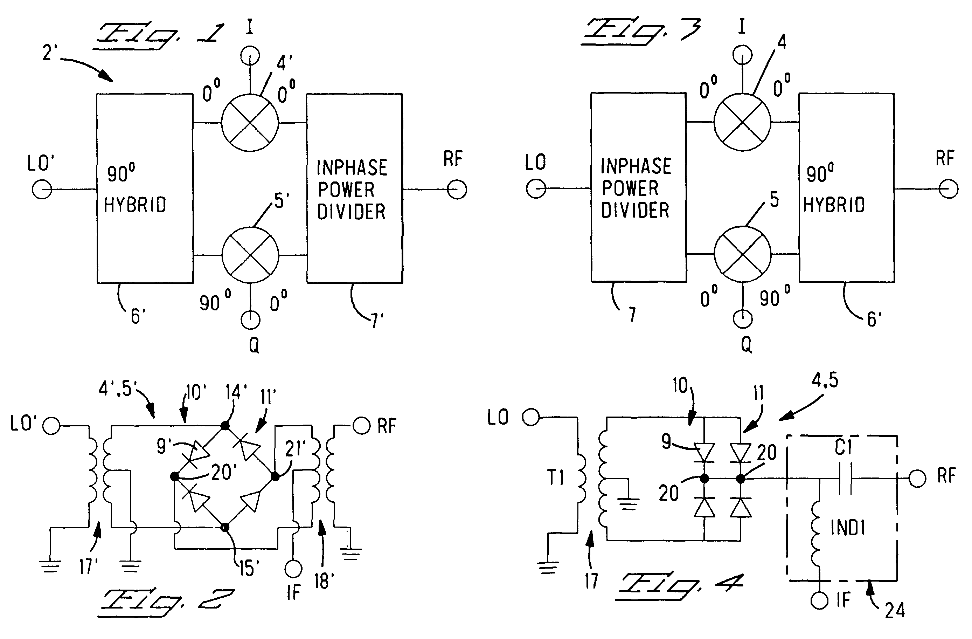

Figure 1 shows a block diagram of a conventional fundamental I-Q modulator having a local oscillator input LO, feeding first and second mixers 4', 5' through a first power divider 6' with 90° phase shift (typically called 90° hybrid). The LO signals are mixed with input IF (intermediate frequency) signals I, Q which are identical signals except for a 90° phase shift therebetween. The I and Q signals are mixed with the LO signals and fed into a second power divider (combiner) 7' which operates in phase (i.e. without phase shift) to produce the modulated RF signal output.

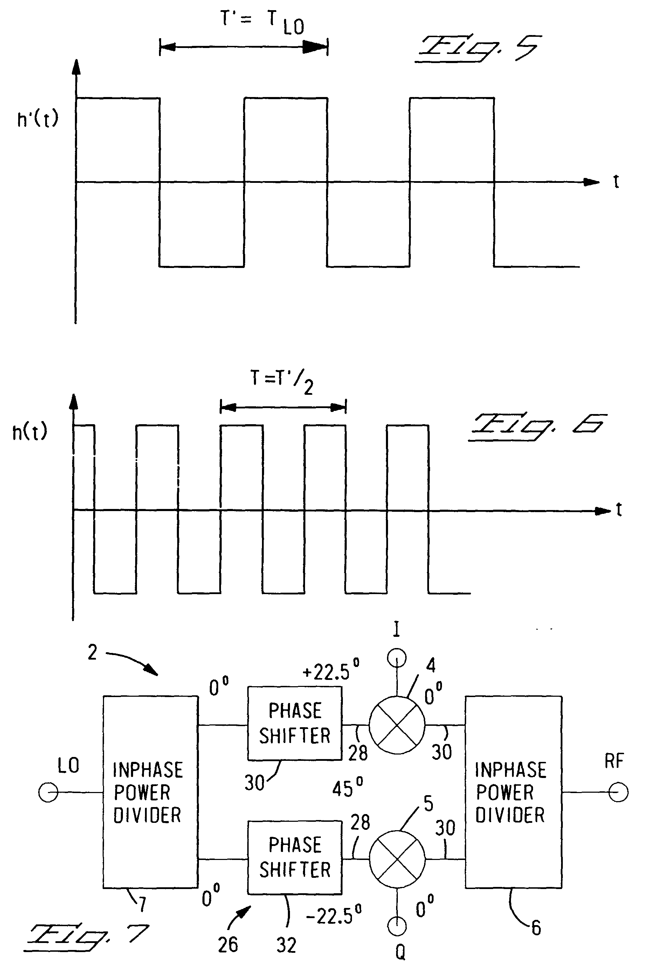

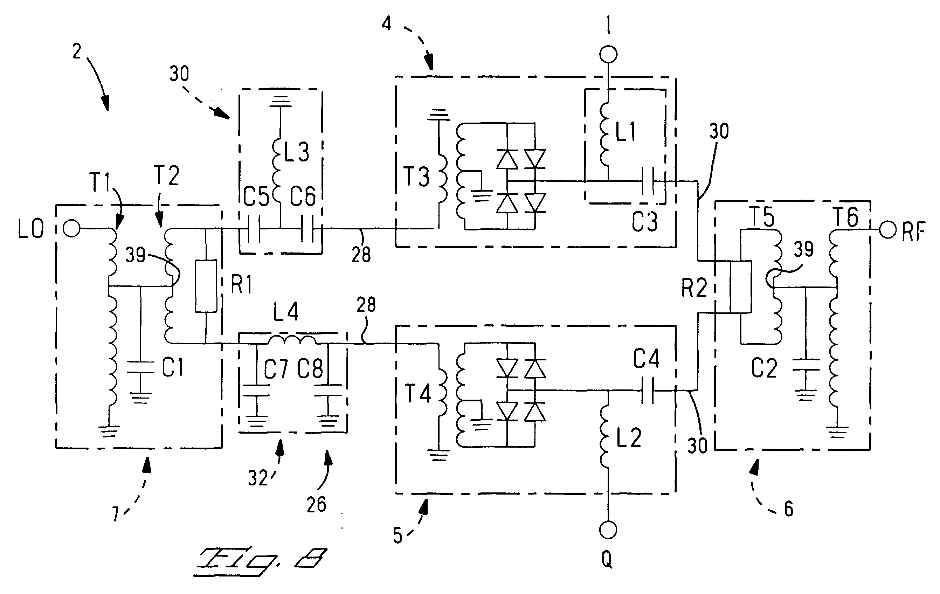

A simple and widely used mixer for the fundamental I, Q modulator 2' is a double balanced mixer illustrated in figure 2, which comprises two pairs of diodes 10', 11' arranged in anti-parallel orientations and connected at their opposite ends 14', 15' to a center tapped transformer 17' coupled to the LO mixer input. A second transformer 18' which is center tapped to the IF (intermediate frequency) port (the I or Q port as the case may be) is connected at its ends to connection points 20', 21' between diodes 9' of the pairs 10', 11' respectively. The transformer 18' is coupled to the RF output. Neglecting transient effects of real diodes, in an ideal situation the time domain transfer function h' (t) is a periodic square wave as shown in figure 5 with a frequency at the LO frequency (i.e. the fundamental frequency). Multiplying the latter signal with the IF input signal generates an RF signal consisting of the fundamental and harmonic frequencies ± the IF frequency (LO ± IF, 2 LO ± IF, 3LO ± IF ...). One sideband of the double sideband is eliminated by the construction of figure 1 because of the 90° phase shift between LO inputs and IF inputs (I, Q) of the mixer. It may be noted that in the fundamental I-Q modulator 2' shown in figure 1, the 90° hybrid may be positioned at the output of the mixer and the inphase power divider at the inputs. As can be seen from the above, the modulator 2' of figure 1 is termed a fundamental I-Q modulator because it operates at the frequency of the local oscillator (i.e. the fundamental frequency).

In general, the higher the operating frequency the more expensive and difficult it is to design and produce a modulator. The need for RF signals at a certain frequency is however determined by the desired application. Harmonic modulators (also called sub-harmonic modulators) require a local oscillator frequency that is half that of a fundamental I-Q modulator, for a given RF operating frequency. Harmonic modulators thus have the advantage with respect to fundamental modulators in that a lower frequency oscillator is required, which reduces cost. Such modulators are also well known and generally have the construction shown in the block diagram of figure 3 whereby an LO signal is fed through a power divider 7 to first and second mixers 4, 5 connected respectively to the IF inputs at quadrature I, Q. The 90° hybrid 6' is positioned at the mixer outputs. Contrary to the fundamental I-Q modulator of figure 1, the 90° hybrid cannot be positioned at the inputs of the mixers 4, 5, because harmonic mixers double the frequency and phase (which would result in a 180° phase shift instead of the desired 90°).

One example of a known harmonic mixer is a single balanced mixer 4, 5 shown in figure 4. The single balanced mixer comprises two pairs 10, 11 of diodes 9 arranged in anti-parallel relationship and connected at opposed ends to a transformer 17 center tapped to ground, that is coupled to the mixer LO input. The diode pairs 10, 11 are connected between diodes 9 of the pairs at connection point 20 to the IF and RF ports via a diplexer LC filter 24, the IF input connected through the inductor L to connection point 20, and the RF output connected to the connection point 20 via the capacitor. The diplexer or low-pass filter 24 prevents the low frequency input signals from leaking through the RF output, but allows the higher frequency mixed signals (2 LO ± IF, 4 LO ± IF, ...) to pass through. When either of the diode pairs 10, 11 is fully forward biased, connection point 20 represents virtual ground because of the center ground tapped coil 17. The zero (or low) impedance of connection point 20 provides an impedance mismatch with the IF input, thereby reflecting the IF signals. During the transition period in switching between the full forward bias of one diode pair to the other diode pair, the connection point 20 exhibits a high relative impedance that also mismatches the IF input impedance and reflects the IF signals. The reflection coefficient of the mixer thus switches from -α to +α during a half cycle of the LO frequency. The time domain transfer function h(t) of the single balanced mixer 4, 5, which is determined by the switching reflection co-efficient, is thus double the frequency LO of the local oscillator. The transfer function h(t) is illustrated in figure 6 as having double the frequency in comparison to the double balanced mixer transfer function h'(t) shown in figure 5. The transfer functions are shown as square waves, but in reality they would be rounded by the sloped response characteristics of real diodes, and in fact functioning of the single balanced mixer depends on real diode characteristics.

Various harmonic modulator designs are for example described in US patent 5,416,449.

Although harmonic modulators have the advantage over fundamental modulators of requiring half the LO frequency, thereby simplifying oscillator design, as well as improving carrier (fundamental frequency) suppression, it would be desirable to further simplify and improve harmonic modulators.

Objects of this invention have been achieved by providing the harmonic modulator according to claim 1. Disclosed herein is a harmonic modulator comprising an LO input interconnected via a power divider to first and second mixers, the mixers connected to IF inputs at quadrature where input signals are substantially at 90° phase difference, and outputs of the mixers are interconnected through a power combiner to an RF output port, wherein the modulator further comprises a 45° phase shifter interconnected to the mixer LO inputs, and wherein the mixers are harmonic mixers that produce an operating signal at substantially double the frequency of the LO signal. Advantageously therefore, the phase shift occurs on the lower frequency side of the modulator, thereby simplifying the design of the phase shifter, increasing reliability and reducing cost. The latter construction also enables provision of similar or identical power dividers (combiners) on the LO and RF side thereby advantageously further simplifying the modulator. Placing the phase shifter on the lower frequency LO side of the modulator also improves performance and quality of the phase shifted signals.

The harmonic mixers may be single balanced mixers comprising first and second diode pairs arranged in an anti-parallel manner and inferconnected at ends thereof to a center ground tapped transformer coupled to the LO input of the mixer. The 45° phase shifter may comprise a substantially +22.5° phase shifter on the LO input to the first mixer, and a substantially -22.5° phase shifter on the LO input to the second mixer. An advantageously simple phase shifter may comprise a low-pass filter (π filter) comprising a pair of capacitors connected to ground at one end and interconnected through an inductor at the other end, the inductor connected in series to the mixer LO input. The other phase shifter may comprise a high-pass filter, for example comprising a pair of capacitors in series on the input line to the mixer and an inductor interconnected at one end therebetween and connected to ground to the other end. A particularly simple phase shifter is thus provided, it may be noted that the ±22.5° represents substantially the center operating phase shift, and that the phase shift of each phase shifter may vary slightly therearound or may not be symmetrical e.g. +30° and -15°. The phase shifter described above is particularly simple, however it is possible to implement other phase shifters of different construction, for example a 45° phase shifter incorporated in the power divider. It is also possible within the scope of the invention to provide other harmonic mixers that double the LO frequency and that are known in the art.

Further advantageous features of the invention are set forth in the claims, or will be apparent from the following description and drawings.

An embodiment of this invention will now be described by way of example with reference to the figures in which;
Figure 1 is a block diagram of a conventional fundamental I-Q modulator;
Figure 2 is an electrical schema of a conventional double balanced mixer that may be employed in the fundamental modulator of figure 1;
Figure 3 is a block diagram of a conventional harmonic modulator;
Figure 4 is an electrical schema of a single balanced mixer that operates at double the LO frequency and could be employed in the harmonic modulator of figure 3;
Figure 5 is a simplified ideal time domain transfer function of the double balanced mixer according to figure 2;
Figure 6 is a simplified ideal time domain transfer function of a harmonic mixer such as the single balanced mixer of figure 4;
Figure 7 is a block diagram of a harmonic modulator according to this invention;
Figure 8 is an electrical schema of an embodiment of a harmonic modulator according to this invention.

Prior conventional fundamental and harmonic modulators have already been described hereinabove with reference to figures 1-6. Further detailed description is not required as the construction of these modulators are known in the art.

Referring to figures 7 and 8, an embodiment of this invention will now be described in more detail. The harmonic modulator 2 comprises an LO input interconnected to first and second harmonic mixers 4, 5 via an inphase power divider 7 and a 45° phase shifter 26. The inputs of the mixers 4, 5 which are interconnected to the LO input will hereinafter be called the mixer LO inputs 28. Each mixer 4, 5 has a further input I, Q respectively which receives IF signals with the same frequency for both mixers, but with a 90° phase shift therebetween. In applications in which harmonic modulators are used, the IF input signals are typically of lower frequency than the LO frequency, and may be data signals to be processed by the modulator, that are in analog or in digital form, for example for use in telecommunications transmission or reception systems. The outputs 30 of the mixers 4, 5 are interconnected to the RF output through an inphase power divider (combiner) 6 that in this embodiment is of similar construction to the first power divider 7, except for the values of resistance R2, inductor T5 and capacitor C2 in order to take into account the different frequency at the LO and RF ends of the modulator.

Although the IF ports I, Q are described above as inputs, and the RF port as an output, it is clear that the modulator can function as a receiver where the RF port is the input, and the IF ports I, Q are the outputs, and in certain applications the modulator may function in both transmit and receive modes. For the purposes of simplification however, reference will be made to the IF ports as inputs and RF port as an output.

The 45° phase shifter may comprise a first phase shifter 30 at the LO input 28 of the first harmonic mixer 4, and a second phase shifter 32 at the LO input 28 of the second harmonic mixer 5. In the present embodiment, the first phase shifter 30 has a center operating phase of 22.5° phase shift, and the second phase shifter 32 has a center operating phase shift of -22.5°. It is however also possible to have non symmetrical phase shifts (e.g. 30° at phase shifter 30 and -15° at phase shifter 32) as long as the phase shift difference between the mixer LO inputs 28 is substantially 45° at the LO frequency. The first phase shifter 30 has the arrangement of a high-pass circuit, for example comprising a pair of capacitors C5, C6 in series on the LO input line 28, connected therebetween to an inductor L3 connected to ground. Alternatively, a high-pass filter could also be formed from a pair of inductors connected in parallel to ground with a capacitor therebetween. The second phase shifter 32 is in the form of a low-pass filter, for example comprising an inductor L4 connected in series on the mixer LO input 28 and connected either side to capacitors C7, C8 in parallel connected to ground. Alternatively a low-pass filter could also be formed from a pair of series inductors connected therebetween to ground via a capacitor. Both filters are designed to allow the LO frequency to pass through but to shift the phase of the voltage by +22.5 and -22.5° respectively for a specific LO frequency. The phase shift of the filters is a function of the frequency, so variations in the LO frequency will move the phase shift away from +22.5° and -22.5° respectively, but in the same direction such that the phase differential of 45° remains substantially constant over a fairly large variation of the LO frequency.

The power divider, which is also a power combiner in the opposite direction of use, comprises a transformer T2 connected at opposite ends to the mixer LO input lines 28 respectively, the transformer T2 center connected to an auto-transformer T1 which is connected to earth at one end and to the LO input at the other end. A resistance R1 is placed in parallel with the center tapped transformer T2 to dissipate any non-symmetrical electrical power component. The interconnection between the transformers T1, T2 is further connected to a capacitor C1 which is connected to ground, and serves as a tuning capacitor for fine tuning the impedance of the power divider. It may be noted that the two inductance coils extending from the center tap connection point 39 are wound in opposite directions to effect the electrical power split or combination.

The second power divider (combiner) 6 has a design similar to the first power divider except that the value of the resistance R2 may differ from R1, and the value of the inductance T5 may differ from the inductance T2. The resistance R2 of the second of the second power divider 6 will fully dissipate the energy of frequency components that are 180° out of phase between the first and second mixer output lines 30 whereas the inphase frequency components will combine at the RF port to provide a single side band (SSB) signal.

The mixers 4, 5 in the present embodiment are single balanced mixers with the characteristics of the single balanced mixer already described with reference to figures 4 and 6. As the single balanced mixers 4, 5 double the frequency and phase of the 45° phase shifted LO signals, the output signals of the first and second mixers 4, 5 respectively, will have a center frequency double the LO frequency (i.e. 2 LO) ± the IF frequency whereby the 2LO frequency component of the first mixer 4 has a phase differential of 90° with respect to the 2LO frequency component at the output 30 of the second mixer 5.

The advantages of a conventional sub-harmonic mixer are thus maintained, namely that the local oscillator signal need only be half that of the operating frequency, which also means that carrier suppression is high. The invention is particularly advantageous over conventional I-Q modulators because of the simple and reliable phase shifter provided in the low frequency portion of the harmonic modulator. The invention further enable simpler power dividers to be provided, in particular by eliminating the need for different power dividers, an inphase and a 90° hybrid.

## Claims

1. A harmonic modulator (2) comprising an LO signal input interconnected via a power divider (7) to first and second harmonic mixers (4, 5) that produce an operating signal at substantially double the frequency of the LO signal, the mixers connected to IF inputs (I, Q) at quadrature and to an RF output through a power combiner (6), wherein the modulator further comprises a 45° phase shifter (26) interconnected to the LO input of the mixers (4, 5).

2. The modulator of claim 1 wherein the phase shifter (26) comprises a +22.5° phase shifter (30) interconnected to the LO input of the first mixer (4), and a -22.5° phase shifter (32) interconnected to the LO input of the second mixer (5).

3. The modulator of claim 1 or 2 wherein phase shifter (26) comprises a first phase shifter (30) comprising a high-pass filter, and a second phase shifter (32) comprising a low-pass filter.

4. The modulator of claim 3 wherein the low-pass filter comprises a pair of capacitors (C7, C8) and a series inductor (L4) therebetween.

5. The modulator of claim 3 or 4 wherein the high-pass filter comprises a pair of capacitors (C5, C6) in series at the mixer input, and interconnected to ground therebetween through an inductor (L3).

6. The modulator of any one of the preceding claims wherein the mixers (4, 5) are single-balanced mixers.

7. The modulator of any one of the preceding claims wherein the inphase power dividers or combiners (6, 7) are of a similar or identical construction.
